# EUROPEAN PATENT SPECIFICATION

(11) **EP 2 183 753 B1**
(45) Date of publication and mention of the grant of the patent: **16.05.2012**
(21) Application number: 08776071.6
(22) Date of filing: 25.07.2008
(51) Int. Cl.: H01F 6/04, F25D 19/00

(54) **COOLING METHODS**
KÜHLVERFAHREN
PROCÉDÉS DE REFROIDISSEMENT

(30) Priority: 10.08.2007 GB 0715670; 15.08.2007 GB 0715948; 09.11.2007 GB 0722098; 09.11.2007 US 937573
(43) Date of publication of application: 12.05.2010
(73) Proprietor: Tesla Engineering Limited, Storrington West Sussex RH20 3EA (GB)
(72) Inventor: BEGG, Michael, Colin, Worthing West Sussex BN14 7PN (GB); GOLDIE, Frederick, Thomas, David, Worthing West Sussex BN13 1QW (GB)
(74) Representative: Mabey, Katherine Frances
(86) International application number: PCT/GB2008/002564
(87) International publication number: WO 2009/022094

(56) References cited:
- EP-A- 1 522 867
- GB-A- 2 432 259
- US-A- 6 107 905
- US-A1- 2006 218 942
- US-A1- 2006 236 709

## Description

The present invention relates to superconducting systems, and more particularly to cooling systems and methods for a superconducting system including one or more superconducting coils.

Superconducting systems are used in many applications, including, for example, rotors, magnetic energy storage devices, generators, motors, and magnetic systems, e.g. magnetic resonance imaging (MRI), or systems for use in particle physics applications, such as particle accelerators. The present invention is particularly, although not exclusively, directed to a superconducting magnet system.

Various methods for cooling coils of superconducting systems have been proposed. Some conventional cooling methods for superconducting coils involve immersing the coil in a liquid cryogenic coolant or "cryogen". The cryogen most commonly used is liquid helium. The cryogen absorbs heat from the superconductor, and is vaporised, thus cooling the superconductor. However, the need to immerse the superconductor in the cryogen has certain drawbacks. For example, this may result in a bulky apparatus as a result of the need to provide a cryogen containing bath around the superconductor. Due to the relatively large quantities of cryogen required, it is generally necessary that the cryogen containing bath is a pressure vessel, capable of withstanding the potentially high pressures which may result from vaporisation of the cryogen on quenching of the superconducting magnet. Quenching is a phenomenon which may occur if the superconducting magnet comes out of its superconducting state and enters a resistive state. This may result in the release of energy from the coil in the form of heat, causing cryogen surrounding the coil to vaporise. Furthermore, it is likely that cryogens, such as liquid helium, will become increasingly scarce in the future, making immersion systems which use large quantities of cryogen less desirable.

Other known cooling methods use thermal conductors, such as copper thermal links, to transfer heat from the superconducting coil to the working fluid of a cryocooler, without using a cryogen as a heat transfer medium. However, these systems also have certain drawbacks. For example, significant temperature gradients may arise over the length of the conductors, degrading performance, of the superconducting coil. This problem may render such systems unsuitable for use in conjunction with larger coils e.g. magnets when it may be necessary to locate the cryocooler at a significant distance from the coil to reduce any interference by the coil with the working parts of the cryocooler.

U.S. 2006/0235709A1 discloses a space-saving superconducting device. U.S. 6107905 discloses a superconducting magnet apparatus. EP 1522867, which is regarded as the closest prior art, discloses a superconducting magnet with increased thermal stability.

The Applicant has realised that there is a need for an improved cooling method and system for a superconducting system.

In accordance with the present invention there is provided:
a superconducting system in accordance with claim 1.

In accordance with the invention, therefore, a cryogen chamber is provided local to the superconducting coil. A liquid cryogen located in the chamber in use may absorb and be vaporised by heat transmitted to it from the superconducting coil to thereby cool the coil. A highly thermally conductive means is specifically provided to facilitate transfer of heat from the superconducting coil to the cryogen chamber to vaporise cryogen located therein in use. The present invention thus uses a thermal conduction path to transfer heat from the superconducting coil to cryogen located in a cryogen chamber in the vicinity of the coil in use. The cryogen chamber is in fluid communication with e.g. connected to a cryogen recondensing unit, whereby in use, cryogen located in the chamber and vaporised by heat from the superconducting coil may flow to the cryogen recondensing unit to be recondensed before returning to the chamber. The recondensed cryogen may then be vaporised once more to start a new cycle.

In this way, the present invention provides a cooling system for the superconducting coil or cools of the system, in which heat is extracted from the coil or coils in a two step process. First of all, heat is transmitted by thermal conduction over the relatively short distance to a local cryogen chamber cryogen to vaporise cryogen present in the chamber in use. In the second stage, the vaporised cryogen acts as a heat transfer medium to remove heat from the vicinity of the superconducting coil, travelling from the cryogen chamber to a recondensing unit.

It has been found that the combination of the two different heat transfer mechanisms, i.e. using the cryogen in its vaporised state as a heat transport medium only in the latter stages of the cooling process to transport heat to the recondensing unit, e.g. over the longer range, with thermal conduction via a specific highly thermally conductive means being used to initially transmit heat from the coil to the cryogen, i.e. over the shorter range, is particularly advantageous, allowing the present invention to address problems associated with both prior art arrangements which rely upon immersion of the coil in a cryogen bath to remove heat from the coil, and those which rely upon the use of thermal conductors to transmit heat over a significant distance directly to the working fluid of a heat pump, such as a cryocooler, without using a cryogen.

In contrast to immersion type arrangements, the present invention allows a significantly smaller quantity of cryogen to be used, and corresponding reductions in the size of the cryogen chamber to be obtained in comparison to prior art cryogen baths. This is as a result of the presence of a thermally conducting means dedicated to facilitating transmission of heat from the coil to the interior of the cryogen chamber to vaporise cryogen, and a recondensing unit for recondensing the vaporised cryogen. The presence of the highly thermally conductive means allows the temperature of the coil to be maintained close to the temperature of the liquid cryogen without needing to provide a substantial quantity of cryogen adjacent the coil in a cryogen bath to act as a cold reservoir. In accordance with the invention, immersion of the coil in cryogen is replaced by thermal contact of the coil with a highly thermally conductive means arranged to transmit heat to the cryogen chamber. As a smaller quantity of cryogen may be present in accordance with the invention, the potential pressures which may arise during quenching of the coil are reduced, providing greater flexibility in the construction of the cryogen chamber, which need not be designed to withstand such high pressures as a conventional cryogen bath. Furthermore, by reducing the size of the cryogen chamber relative to a conventional cryogen bath, and providing a highly thermally conductive means to transport heat to the chamber, greater flexibility in the construction of the overall system, e.g. its size and configuration is provided, as the cryogen does not need to be in direct contact with the coils.

As the cryogen chamber is local to the superconducting coil, the distances over which heat must be transmitted by thermal conduction are relatively small in use, reducing the quantity of thermally conductive material required, and avoiding problems associated with thermal losses and temperature gradients which may occur when heat is transmitted over a longer range e.g. directly to a cryocooler of a recondensing unit using thermal links. In accordance with the invention, heat need only be transmitted as far as the local cryogen chamber by conduction to enable it to vaporize the cryogen in use, with the vaporised cryogen then being used to heat away from the vicinity of the coil, e.g. to a cryocooler if desired. The use of vaporised cryogen as the heat transport medium over the longer range to a recondensing unit, may allow heat be conveniently transferred over relatively great distances, as the mass and size of apparatus required to transport heat over a given distance using vaporised cryogen is very much smaller than would be required to transport a corresponding quantity of heat using a solid thermal link of e.g. copper. This allows the recondensing unit to be located at greater distances from the cryogen chamber than prior art arrangements permit, without compromising efficiency of the cooling system to a detrimental degree. By removing the constraints on the distance at which the coil may be located relative to the recondensing unit, the present invention may allow larger superconducting coils to be used, as the recondensing unit may be located at a sufficiently great distance from the coil to avoid unacceptable interference with its operation by the coil. Furthermore, the use of the cryogen for transporting heat to the recondensing unit has been found to allow better vibration isolation to be obtained between the coil and recondensing unit, which may include a motor and other moving parts.

It should be appreciated that all references to thermal conductivity herein, unless stated otherwise, refer to thermal conductivity at cryogenic temperatures. Cryogenic temperatures may be taken to be temperatures of less than 100 K, and thus, the highly thermally conductive means is highly thermally conductive at cryogenic temperatures of less than 100K. In typical embodiments, the cryogenic temperatures at which the system is operated may be less than 40K.

In accordance with a second aspect of the invention there is provided, a method of cooling a superconducting coil in accordance with claim 12.

The present invention in the further aspect may include any or all of the features described in respect of the first aspect of the invention.

Although the present invention in accordance with any of its aspects and embodiments is applicable to any superconducting system comprising a superconducting coil to be cooled, preferably the superconducting system is a superconducting magnet system, and preferably the superconducting coil is arranged to provide a magnetic field when current flows through its windings.

The present invention may be applied to high temperature or low temperature systems. However, the invention is particularly applicable to so-called "low temperature" superconducting systems. In these systems the superconducting coil of the system must be operated at a temperature at or below a critical temperature in order to be able to achieve and/or maintain superconductivity. Critical temperatures for these low temperature superconductors are in the cryogenic order, typically of, for example, less than 20K. For example, niobium titanium (NbTi) and niobium tin (Nb₃Sn), which are superconducting materials commonly used in low temperature superconducting systems, having superconducting transition temperatures of 10.1K and 18.5K respectively. To provide adequate superconducting performance, superconductors comprising these materials must be cooled to well below these critical transition temperatures, e.g. to allow superconducting coil of a super magnet to be able to carry large current densities in the presence of high magnetic fields.

While the invention has been described in detail in respect of one superconducting coil, it will be appreciated that the system may comprise any number of coils, and, if not explicitly stated, references to "the coil" should be understood to refer to "the at least one coil", and this may be the, each or a coil, where a plurality of coils are present. The second or any further coil may be of the same construction as the first, and may include any or all of the features described in respect of the first coil.

The at least one superconducting coil may be of any size and configuration, depending upon the intended application of the system. The coil may be regular or irregular in shape. In some embodiments, the superconducting coil is annular. The coil may then be in the shape of a part or entire ring.

The coil or coils may be formed of any suitable material which is superconducting at low e.g. cryogenic temperatures. Preferably the at least one coil comprises niobium titanium and/or niobium tin. The coil may comprise an outer casing, e.g. in the form of a sleeve or sheath to protect the filament(s) defining the windings, or the filaments may be exposed.

In accordance with the invention, heat is transferred by conduction between the cryogen located in the cryogen chamber in use, and the superconducting coil, via a highly thermally conductive means. Any material having a suitably high level of thermal conductivity at cryogenic temperatures may be used to provide the highly thermally conductive means, and examples of suitable materials are known in the art. The highly thermally conductive means may comprise one or more different materials, which may be of the same or different thermal conductivity, provided that any composite exhibits high levels of thermal conductivity. Preferably the highly thermally conductive means comprises or consists of a metal. For example, the highly thermally conductive means may comprise aluminium. However, in particularly preferred embodiments the highly thermally conductive means comprises or consists of copper.

The highly thermally conductive means typically has a higher thermal conductivity than materials conventionally used to provide structural components in conventional supermagnet systems. Such materials typically have a low thermal conductivity at cryogenic temperatures of less than 10 W/m/K, and include materials such as stainless steel, aluminium alloy, or glass reinforced polyester. The highly thermally conductive means therefore has a high thermal conductivity relative to stainless steel.

Preferably the highly thermally conductive element has a thermal conductivity in the range of greater than 100W/m/K at cryogenic temperatures, and more preferably greater than 200W/m/K. As described above, references to cryogenic temperatures herein refer to temperatures of less than 100K. Thus, the thermally conductive means should be capable of exhibiting thermal conductivity within the ranges described throughout this temperature range, i.e. at any temperature below 100K. In practical terms, the lowest temperatures likely to be encountered would be in the order of 4K In typical embodiments, the system may be operated at temperatures between 4K and 50K, and the highly thermally conductive means exhibits the described thermal conductivity throughout this range. Any other ranges for thermal conductivity described herein, e.g. with reference to other components of the system, should similarly be taken as being with reference to temperatures of less than 100K.

Preferably the highly thermally conductive means has a thermal conductivity in the range of greater than 100W/m/K at room temperature.

The thermally conductive means may be of any form and arranged in any manner to facilitate transfer of heat by thermal conduction between the coil and cryogen located in the cryogen chamber in use. For example, the thermally conductive means may comprise one or more thermally conductive connectors, and/or thermally conductive layer(s).

The thermally conductive means extends the entire distance between the at least one coil and the interior of the cryogen chamber. In this way, the thermally conductive means provides a direct thermal conduction path between a surface of the coil and the interior of the cryogen chamber in order to be able to directly contact cryogen located in the chamber in use. Preferably the thermally conductive means is arranged to directly contact a surface of the coil at one end thereof, and to directly contact cryogen located in the ayogen chamber in use at the other end thereof. The thermally conductive means may extend along any suitable path or paths between the coil and cryogen chamber, and may extend through or around any intervening layers.

The thermally conductive means may be arranged to transmit heat between the coil and the cryogen chamber at only a selected point or points of a surface area of the coil, or at a plurality of points, which may be in the form of a continuous or discontinuous area. In some embodiments, the thermally conductive means may be arranged to collect heat from different parts of the coil and to deliver the heat to the cryogen chamber. In this manner, the thermally conductive means may transport heat from parts of the coil which are not directly or indirectly adjacent the cryogen chamber, or at least to a cryogen containing part thereof, to cryogen in the chamber in use.

It will be appreciated that in effect, the present invention replaces cryogen provided in a cryogen bath arranged adjacent the coil in order to immerse the coil with the thermally conducting means which contacts the coil to remove heat therefrom and transfer it to a cryogen chamber, providing greater flexibility in the location and size of the cryogen chamber relative to the coil. The greater the area of contact between the coil and the thermally conductive means, the greater the efficiency with which heat may be extracted from the coil.

In preferred embodiments, the thermally conducting means is in contact with a substantial portion of the surface area of the coil. In embodiments, the thermally conductive means extends around at least portion of a circumference of the coil. In this way, heat may be extracted directly from a greater portion of the coil to increase the rate of cooling. Preferably the thermally conductive means is arranged to contact at least 25%, more preferably at least 50%, and most preferably at least 75% of a surface of the coil. The thermally conductive means may at least partially surround the coil. In these embodiments, the thermally conducing means may contact a radially outer surface of the coil. Preferably the thermally conductive means is arranged to contact an area of the coil extending around at least 25%, more preferably at least 50%, and most preferably at least 75% of a circumference of the coil.

The extent to which the thermally conductive means extends relative to the interior surface of the cryogen chamber is not critical, provided that the thermally conductive means is arranged to facilitate the transfer of heat to the interior of the chamber in some manner. The thermally conductive means may, for example contact the interior of the chamber at only one point. As the present invention allows the size of the cryogen chamber and volume of cryogen present to be significantly reduced relative to prior art arrangements which rely on immersion of the coil or coils in cryogen, heat may more readily be transferred to any cryogen present within the limited area of the cryogen chamber. The way in which the thermally conductive means is arranged relative to the cryogen chamber may be selected as appropriate depending upon factors such as the size of the cryogen chamber, distance between the cryogen chamber and the coil, and quantity of cryogen located in the chamber in use to achieve a desired level of heat transfer. The thermally conductive means may penetrate a wall of the cryogen chamber, or, in some embodiments, it is envisaged that the thermally conductive means may at least partially define a wall of the cryogen chamber.

In some embodiments, the thermally conductive means may be arranged to distribute heat from one part of the cryogen chamber to another. The thermally conductive means may therefore be arranged such that it may conduct heat from a part of the cryogen chamber which does not contain cryogen in use to a part of the cnamber which does contain cryogen. In some embodiments, the regions are different regions around a periphery, e.g. circumference of the chamber. In these embodiments, the thermally conductive means may contact an interior surface of the cryogen chamber at one or more points, which may extend over a continuous or discontinuous area of the cryogen chamber, in a similar manner to the way in which the thermally conductive means may be arranged relative to the coil, as discussed above The thermally conductive means may extend around a periphery, or circumference, of the cryogen chamber in some embodiments.

In these embodiments, heat may still be transmitted to cryogen disposed in the cryogen chamber in use without the cryogen chamber, or at least a portion thereof which is filled with cryogen, needing to be coextensive with the coil, allowing further reductions in the size of the cryogen chamber, and amount of cryogen required, to be obtained in contrast to prior art immersion type systems. However, due to the relatively small size of the cryogen chamber which may be used in accordance with the invention, and its proximity to the coil, it is not necessary to provide any heat distribution arrangement along these lines.

In use, the vaporised cryogen travels by diffusion to the recondensing unit. The cryogen chamber may therefore comprise a mixture of liquid cryogen and vaporised cryogen at different stages in its cycle of vaporisation and condensation as it travels from a region proximate the coil to the recondensing unit and back again.

The cryogen chamber may be provided in any manner which ensures that when a cryogen is located within the chamber in use, heat may be transmitted to the cryogen from the coil by the highly thermally conductive means. The cryogen chamber is local to the superconducting coil. In other words, it is located in proximity thereto, and may be adjacent to the coil. For example, the chamber may be separated from the coil by one or more intervening layers. The cryogen chamber is arranged such that cryogen located in the chamber in use does not directly contact the superconducting coil. In other words, the coil is not fully or partially immersed in liquid cryogen.

As the highly thermally conductive means transports heat to the interior of the cryogen chamber, the walls of the cryogen chamber may be of low thermal conductivity at cryogenic temperatures, e.g. less than 10W/m/K. However, it is envisaged that the thermally conductive means might form a wall of the cryogen chamber in some embodiments.

It will be appreciated that as embodiments of the present invention need only contain a relatively small quantity of cryogen, the cryogen chamber may be relatively small in dimension, allowing a much more compact arrangement to be obtained than in conventional systems which immerse the coil fully or partially in a cryogen bath. The cryogen may be confined to a limited area around the coil defined by the position of the cryogen chamber. This provides the ability to make the superconducting coils, and other components of the system significantly smaller and cheaper than conventional systems permit. Furthermore, as the quantities of cryogen used are relatively small, the system may be more economic to run, and the reduced consumption of cryogen may be advantageous in reducing demand on the already depleted supplies of cryogen, e.g. liquid helium, which may become more scarce in the future.

While the present invention allows the amount of cryogen present to be significantly reduced in comparison to conventional arrangements, it may be desirable to use volumes of cryogen which are larger than required to provide the ability for the system to continue to function if the cooler fails. The present invention may be applied to systems having cryogen chambers with a wide range of volumes, for example from 1 liter to 500 liter, or, in some embodiments from 2 liters to 100 liters.

In some embodiments, the cryogen chamber at least partially surrounds the superconducting coil. The cryogen chamber may or may not completely surround the coil. In embodiments, the cryogen chamber circumferentially surrounds the coil. In embodiments, the cryogen chamber extends around at least 50%, and more preferably at least 75% of the circumference of the coil. In embodiments, the cryogen chamber is annular. The cryogen chamber is preferably not coextensive with the coil. In preferred embodiments there are areas of the coil which are adjacent the cryogen chamber and there are areas which are not adjacent the cryogen chamber. For example, it is not necessary that the cryogen chamber extend over the entire outer surface area of the coil.

It will be appreciated that in embodiments in which more than one coil is present, one or more cryogen chambers may be provided associated with each superconducting coil of the system, or one cryogen chamber may be associated with more than one coil.

In accordance with the invention, once heat has been transferred from the coil to cryogen in the chamber, heat is transmitted the entire remaining distance to the recondensing unit by the cryogen. This is in contrast to some prior art systems in which solid thermal conductors transmit heat directly to the working fluid of the recondensing unit, and not to a liquid cryogen which is vaporised to act as a heat transport medium.

The cryogen chamber is connected to the recondensing unit in a manner which allows liquid or vaporised cryogen to travel between the cryogen chamber and recondensing unit in use. Preferably the cryogen chamber is connected to the recondensing unit using a pipe, i.e. a hollow pipe through which vaporised cryogen may flow. The pipe should be formed of a material which is of low thermal conductivity at cryogenic temperatures, and preferably has a thermal conductivity of less than 10 W/m/K. Preferably the cryogen chamber comprises an outlet to the pipe. Preferably the connecting pipe is a rigid pipe.

Preferably the pipe extends the entire distance between the cryogen chamber outlet and the recondensing means, i.e. a cryogen contacting part thereof. It will be appreciated that where a plurality of coils are present, the recondensing unit may be associated with one or more coils, and there may be one or more recondensing unit associated with each coil.

The connecting pipe may be of any suitable length. In preferred embodiments in which the superconducting coil is a superconducting coil of a superconducting magnet, the recondensing unit should be located at a sufficient distance from the superconducting coil to reduce the risk of interference to the operation of the recondensing unit by the magnetic field associated with the coil. Typically, the larger the superconducting coil, the larger the stray magnetic field associated with the coil, and the further it may be necessary to locate the recondensing unit from the superconducting coil. In accordance with the invention, the recondensing unit may be located at distances as great as in the order of 1 m or more from the coil if necessary, allowing the cryocooler of the recondensing unit to be located out of a region subject to interference by the coil. In conventional arrangements using a thermal conductor to transport heat the entire distance from the coil to the recondensing unit, the size and mass of solid thermal conductor required to transport heat over a corresponding distance would be prohibitive.

Preferably the system is arranged to permit the recondensed cryogen to return to the cryogen chamber under the influence of gravity. In preferred embodiments, the recondensing unit is therefore arranged to be above the level of the cryogen chamber in use to permit the recondensed cryogen to return to the cryogen chamber under the influence of gravity, e.g. by dripping back down into the cryogen chamber.

The recondensing unit may be of any suitable construction. Preferably the recondensing unit comprises a cryocooler. A cryocooler is a device well known in the art of low temperature superconductivity, and is a reciprocating heat engine which uses gas as a working fluid to transfer heat from one or more cold stages to room temperature. Preferably the recondensing unit thus comprises a working fluid. The cryocooler may be of any suitable construction which provides the required level of cooling of the cryogen for a given application. For example, larger coils e.g. of a larger magnet, will require greater levels of cooling power. Preferably the recondensing unit comprises at least one cooling finger upon which cryogen may recondense in use.

The present invention extends to a system in accordance with the invention in any of its aspects or embodiments including a cryogen. Preferably the cryogen is liquid helium.

In embodiments in which the cryogen chamber contains cryogen, preferably at least a part of the cryogen chamber does not include liquid cryogen, and the method comprises only initially partially filling the cryogen chamber with cryogen. In preferred embodiments, the cryogen chamber is initially filled with liquid cryogen to a level of less than 50% of the height of the chamber. This is the level prior to use of the apparatus, and any vaporisation of the cryogen. In these embodiments, if desired, heat may still be transferred from regions of the coil or cryogen chamber other than those adjacent the cryogen by an appropriate configuration of the thermally conductive means to enable the entire, or a greater part, of the cryogen chamber to participate in cooling.

The present invention provides a rotatable system in which cooling of the coil still occurs even when the coil is rotated. Preferably the coil, (and its cryogen chamber), may be rotated by up to 90 degrees in either direction, without interfering with the cooling of the coil. This may be achieved by providing a cryogen chamber which at least partially surrounds the coil, and only partially filling the chamber with cryogen in use, such that the cryogen may still surround at least a part of a circumference of the coil if the coil is rotated. Tilting of the coil and the cryogen chamber may then simply result in the cryogen flowing around the coil to find its own level once again. These embodiments are particularly applicable to annular coils in which the cryogen chamber at least partially surround the coil. Preferably the cryogen chamber is circumferentially curved in these embodiments. The level of rotation possible may ultimately be constrained only by the ability of the recondensed cryogen to return under the action of gravity to the chamber in those preferred embodiments in which the recondensed cryogen returns to the chamber in this manner.

It will be appreciated that the system of the present invention includes a cryogen circuit, being the parts of the system through which cryogen may flow during its cycles of vaporisation and, preferably, recondensation. This circuit comprises the cryogen chamber, recondensity unit, and any connecting pipe or pipes.

In some embodiments of the invention, the cryogenic circuit is sealed, such that a fixed quantity of cryogen will be present throughout operation of the system, e.g. through cooldown, warmup, or quench. In some embodiments, the sealed circuit may incorporate an expansion vessel to accommodate the increased volume of the cryogenic working substance at higher temperatures e.g. room temperature. In other alternative embodiments, the sealed circuit may be of constant volume, and designed to withstand the additional pressure of the cryogenic substance at higher temperatures e.g. room temperature.

As discussed above, the present invention avoids the need to locate a cryogen bath around the coil. The present invention allows the superconducting coil to be mounted in a room temperature vacuum vessel, preferably separated from the environment by only one or two radiation shields, and some insulation. It will be appreciated that the vacuum vessel need not be capable of withstanding the large overpressure which may occur should the coil quench. This is because the amount of cryogen present in the system which might be caused to boil off in this situation is relatively low, and insufficient to require the use of a pressure vessel, in contrast to conventional arrangements using a cryogen e.g. liquid helium bath. If any cryogen is reduced In vapour form during a quench, it may safely be released into the environment, or collected and recondensed for reuse. In preferred embodiments, the or each coil is mounted in a vacuum vessel, preferably a room temperature vacuum vessel. Preferably the vacuum vessel provides the outermost layer of the system. Preferably one or more radiation shields are located outwardly of the or each coil, preferably between a vacuum vessel and the coil. Preferably one or more layers of insulation are located between the (outermost) radiation shield and the vacuum vessel wall.

As a highly thermally conductive means is provided to facilitate transfer of heat between cryogen located in the cryogen chamber in use and the superconducting coil, and due to the use of a small cryogen chamber including a relatively low quantity of cryogen which is recondensed in use, the present invention provides a more compact arrangement than prior art arrangements including a conventional cryogen bath may provide, and by eliminating the need to immerse the coil in a bath of cryogen, greater freedom in the design of the system is provided. For example, the cryogen chamber may be located at a short distance from the coil to facilitate manufacture, or improve coil support and stress management for a given configuration of coil, and materials may be selected for the coil, and other surrounding parts, which need not necessarily be suitable for immersion in liquid helium.

The system further comprises a support means for supporting the coil. Due to the presence of the thermally conductive means, it is possible to located a poor, or non thermally conductive layer between the cryogen chamber and the superconducting coil without compromising the ability of the cryogen to cool the coil in use, as heat may still be transmitted to the cryogen via the thermally conductive means. According to the invention, a support is located between the coil and the cryogen chamber. According to the invention, a support means is provided outwardly of the coil, and at least partially circumferentially surrounds the coil or coils. In these embodiments of the invention, it has been found that the superconducting coll may operate in more extreme conditions than a coil wound conventionally on an internal former and cooled by a cryogen located directly adjacent and outward of the coil e.g. a helium bath.

It may be possible in some applications to eliminate the need for any internal support of the coil. The use of an external support may maximise space available within the coil, and reduce attenuation of the effects of the coil in the region to the interior thereof, allowing reductions in the size of the coil. For example, a similar magnetic field may be obtained using a smaller diameter coil than in arrangements which rely upon the use of an internal support, allowing the apparatus to be made more compact.

The support means may be or comprise any suitable material or materials to provide a required level of support for the coil, having regard to e.g. the size and configuration of the coil, and whether any additional support is present. Preferably the support means comprises or is formed of a different material to the highly thermally conductive means. Preferably the support means has a low thermal conductivity at cryogenic temperatures, preferably in the range of less than 10W/m/K. Preferably the support has a lower thermal conductivity than the highly thermally conductive means at cryogenic temperatures. In some embodiments the support is a stainless steel support. In embodiments in which the cryogen chamber surrounds the support means, the cryogen chamber extends over only a selected portion of an outer surface of the support means i.e. there are areas of the support means which are not adjacent the cryogen chamber in use. Preferably the cryogen chamber covers a surface area which is less than of the area of the outermost surface of the support means. The cryogen chamber may extend over a corresponding part of the support means to that part of the coil over which it extends.

In some embodiments, the support means defines at least a part of the cryogen chamber. For example, at least an inner wall of the cryogen chamber may be provided by the support means. In embodiments, the support means comprises a cavity therein which defines at least a part of the cryogen chamber. In some embodiments, the cavity is an open cavity, and most preferably is in the form of a channel defined in an outer surface of the support In these embodiments, the support means may define at least one cryogen receiving channel in the outer surface thereof. The channel may be a circumferentially extending channel. The channel may then extend around the entire circumference of the support or only a part thereof.

According to the invention one or more thermal conductors are arranged to facilitate heat transfer from the at least one superconducting coil to the cryogen chamber to vaporize cryogen contained therein in use and thereby remove heat from the at least one coil, the one or more thermal conductors being highly thermally conductive at cryogenic temperatures.

In accordance with the invention, each of said one or more thermal conductors preferably has a thermal conductivity of at least 200 W'm/K at cryogenic temperatures. The one or more thermal conductors are preferably formed of copper. The one or more thermal conductors are arranged to provide a direct thermal conduction path between the surface of the superconducting coil and the interior of the cryogen chamber. The one or more thermal conductors may be arranged such that they may conduct heat from a part of the cryogen chamber which does not contain cryogen in use to a part of the cryogen chamber which does contain cryogen in use. The cryogen chamber may at least partially circumferentially surround the coil. The one or more thermal conductors may be arranged to conduct heat from a part of the coil which is not surrounded by the cryogen chamber to the cryogen chamber in use.

The system may be arranged such that recondensed cryogen may return to the cryogen chamber under the influence of gravity. The superconducting system may be a superconducting magnet system, the superconducting coil being arranged to generate a magnetic field when an electric current is passed therethrough.

The system further comprises a support for supporting the coil, wherein the support is located between the superconducting call and the cryogen chamber. The support at least partially surrounds the coil. The support has a thermal conductivity at cryogenic temperatures of less than 10 W/m/K. In embodiments the ore or more thermal conductors may have a higher thermal conductivity than the support.

The system may comprise cryogen in the cryogen chamber. The chamber may contain liquid cryogen which fills the cryogen chamber to a level of less than 60% of the height of the chamber.

Some preferred embodiments of the present invention will now be described by way of example only, and with reference to the accompanying drawings of which
Figure 1 is a longitudinal cross-sectional view taken in the vertical direction along the longitudinal axis of a superconducting magnet system incorporating the cooling system of the present invention, and which view corresponds to the section along line 1-1 of Figure 3;
Figure 2 is a transverse cross-sectional view taken in the vertical direction along the line 2-2 of Figure 1 from one end of the system;
Figure 3 illustrates schematically a perspective view of the system shown in Figures 1, and 2 indicating the relationship of the coils at each end of the system to one another, and their respective recondensing units, with some details omitted for clarity;
Figure 4 illustrates an arrangement in which the coil and support are housed within a vacuum vessel including a helium bath; and
Figure 5 is a view corresponding to that of Figure 4 but eliminating the helium bath.

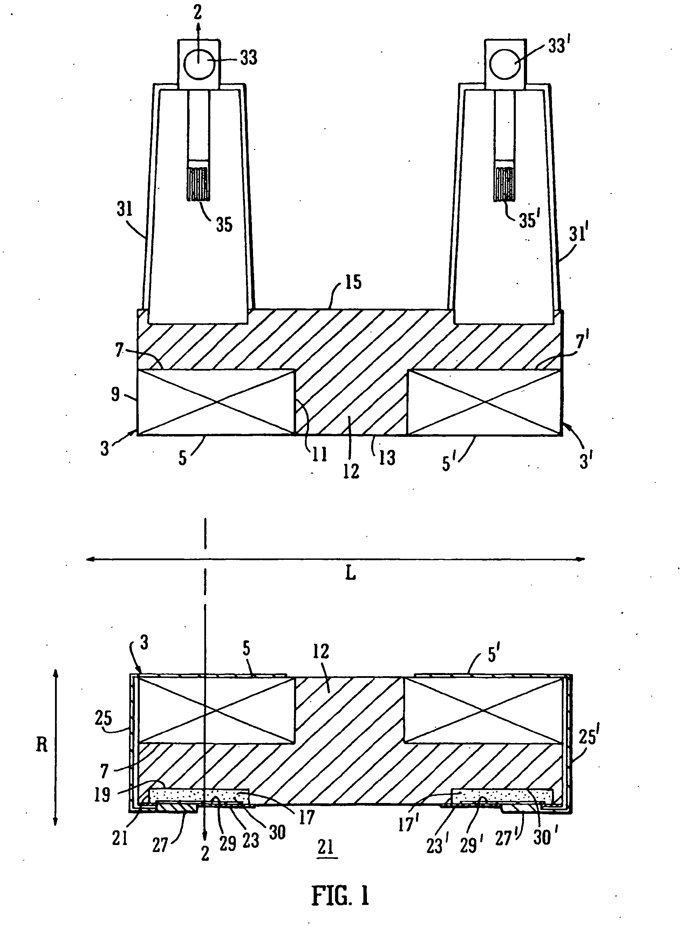

A preferred embodiment of the present invention will be described with reference to Figures 1 to 3. The system is a superconducting magnet system. The system is generally annular in shape, and defines a length L along a longitudinal axis, and a dimension R in a radial direction perpendicular thereto. The system comprises first and second superconducting coils 3, 3" which are annular in shape, and mounted at opposed axial ends to the interior surface of a common support 12. The coils are arranged to provide a magnetic field when a current is passed through their windings in use. The support 12 is in the form of a cylindrical sleeve.

- It will be appreciated that the construction of the system in the region of the second superconducting coil 3' is identical to that in the region of the coil at the other end, the first superconducting coil 3, and thus, the present invention will be described in detail with respect to the first coil 3 and its associated cooling system. The corresponding parts of the system relating to the second superconducting coil 3' are denoted with the same reference numerals, but annotated with a prime (" '") sign. For simplicity, only the main features of the system in respect of the second superconducting coil 3' are labelled.

The coil 3 is a low temperature superconducting coil of niobium titanium or niobium tin, which materials behave as a superconductor only below a critical temperature In the case of niobium titanium and niobium tin, the superconducting transition temperatures are 10.1K and 18.5K respectively. In order to provide good performance, and be able to carry large current densities in the presence of high magnetic fields, superconducting coils made of these materials must be cooled to well below the superconducting transition temperatures. The superconducting coils may include a protective sheath surrounding the filaments of the coil as known in the art. The superconducting coil is not wound on any central mandrel, and is supported only by the support 12 located radially outwardly of the coil. A cavity 4 is defined at the centre of the annular coil 3. It will be appreciated that the invention is applicable to any other types of coil used in superconducting applications, regular or irregular in shape, such as, for example, dipole, quadrupole, sextupole, D-shaped coils, or other coils, used in applications such as stellarators, particle accelerators, tokamaks etc.

The support 12 includes a radially innermost surface 13, and a radially outer surface 15. The first superconducting coil 3 is mounted in a cavity which extends circumferentially around the inner surface 13 of the support means 12. The first superconducting coil 3 includes a radially inner surface 5 and a radially outermost surface 7 which contacts an inner surface 13 of the support. The superconducting coil also defines first and second surfaces 9 and 11 connecting the inner and outer surfaces 5 and 7. The support 12 is formed of a high strength material which is of low thermal conductivity under cryogenic temperatures, such as stainless steel. Stainless steel has a thermal conductivity of around 0.2W/m/K at cryogenic temperatures. The support 12 is also annular in shape.

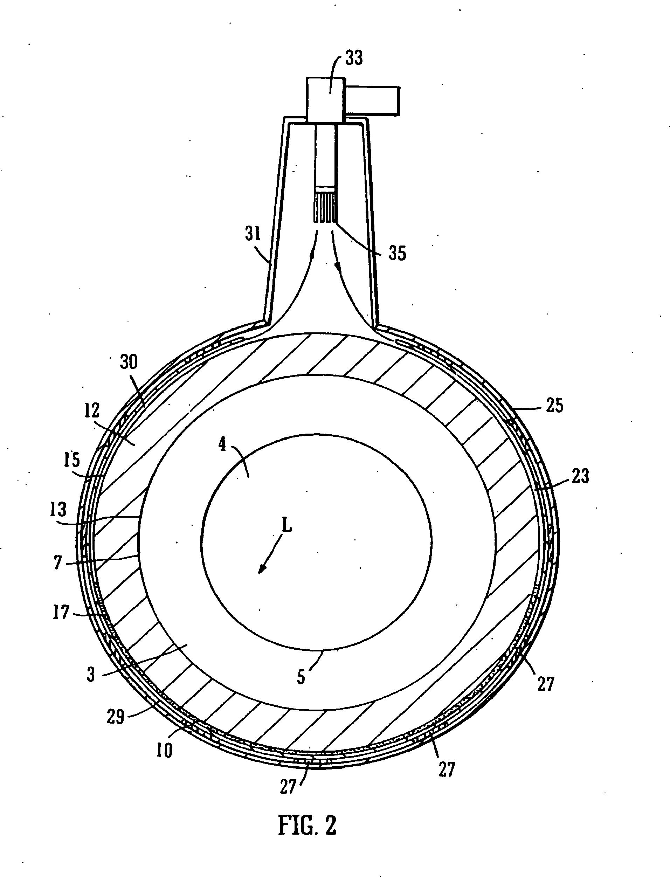

Figure 2 shows more clearly how the support 12 circumferentially surrounds the entire perimeter of the coil 3.

A cryogen chamber 17 is defined in part by the support 12. The cryogen chamber 17 is disposed radially outwardly of the support 12. A recessed channel 30 is provided in the outer surface 15 of the support 12. The recessed channel 30 is spaced radially from the outer surface of the superconducting coil by the support 12. The channel 30 defines an inner wall 19 and axially spaced side walls 21.

A cover plate 23 which extends circumferentially around the support 12 is welded to the outer surface of the support 12 on either side of the channel 30 to close the channel and define the cryogen receiving chamber 17.

Figure 2 more clearly shows that the channel 30 extends circumferentially around the support 12 in the region corresponding to the position of the superconducting coil 3. In use, as shown by the shaded part of the chamber 17 in Figures 1 and 2, the chamber is filled with a quantity of cryogen, such as liquid helium. The chamber extends all the way around the circumference of the coil and support other than a region at the base of an outlet to a pipe 31 which leads to a recondensing unit 33. In this way, a closed chamber 17 which extends circumferentially around the support 12 and superconducting coil 3 is provided, which is not in direct thermal contact with the superconducting coil but instead is spaced therefrom by a portion of the low thermal conductivity support 12.

As the support 12 is of low thermal conductivity, or may not exhibit any thermal conductivity properties at all, in order to provide a thermal conduction path between the superconducting coil and the interior shape of the cryogen chamber 17, a highly thermally conductive means 25 is provided. The highly thermally conductive means 25 is in the form of a copper connector soldered at one end to an inner surface 5 of the superconducting coil 3 (see Figure 1). The copper thermally conductive means has a thermal conductivity at cryogenic temperatures in the order of at least 20W/m/K at cryogenic temperatures. This is significantly greater than the thermal conductivity of materials conventionally used n the construction of structural parts of superconducting systems, such as, for example, stainless steel, aluminium aloy or glass reinforce polyester, which respectively have thermally conductivities at cryogenic temperatures of around 0.2 W/m/K, 2 W/nVK and 0.01 W/m/K.

The thermally conducting means 25 extends around the edge of the superconducting coil 3 and support 12, with its other end terminating in a plug 27. The plug 27 penetrates the cover plate 23 and has a contact plate 29 soldered to its innermost facing surface. The contact plate 29 is attached to the inner surface of the cover plate 23 within the cryogen chamber 17. In this manner, the contact plate 29 defines a part of the inner surface of the chamber 17. The highly thermally conductive member 25, the plug 27 and the contact plate 29 are all formed of highly thermally conductive materials, such as copper. The plug 27 may be electron beam welded to the cover plate 29. The thermally conducting member is of higher thermal conductivity than the support 12.

As may be seen more clearly in Figure 2, the thermally conductive means 25 extends circumferentially around the entire outer circumference of the cryogen chamber 17, being arranged radially outwardly thereof, with plugs 27 penetrating the cover plate defining the outer wall of the chamber at circumferentially spaced points. The inner contact plate 29 which is provided inside the cryogen chamber extends around the entire internal circumference of the interior of the cryogen chamber. In this manner, heat may be transmitted from any part of the coil to any part of the interior of the cryogen chamber, and the thermally conductive means may distribute heat from a part of the cryogen chamber adjacent one part of the coil to a part adjacent another part of the coil. In practice, although cryogen is located in only the lower part of the cryogen chamber as shown in Figure 2, heat may be transmitted from parts of the coil in the upper regions which are not adjacent a part of the cryogen chamber which is filled with cryogen to the lower part of the chamber in order to be absorbed by the cryogen to vaporize the cryogen by the thermally conductive means. The chamber may, for example, be filled with liquid cryogen up to a level which is around 50% of the height of the chamber.

In an upper region of the system, a pipe 31 opens into the cryogen chamber at the base thereof, and leads to a recondensing unit 33. The pipe has an outlet at its lower end which opens into the cryogen chamber to allow cryogen to be transferred into the pipe when it is vaporized in the cryogen chamber to reach the recondensing unit 33. This is achieved by interrupting the cover plate along a portion of the circumference of the support and coil in the region of the base of the outlet to the pipe. The recondensing unit is in the form of a cryocooler which includes a working fluid and a cooling finger 35 upon which vaporized cryogen may recondense before dropping back down onto the support and falling back into the cryogen chamber under the influence of gravity.

Operation of the system to cool the coil 3 will now be described. A liquid cryogen, such as liquid helium is located in the cryogen chamber as schematically illustrated in Figures 1 and 2, which show the cryogen as a shaded area. The liquid cryogen is initially filled to around 50% of the height of the cryogen chamber. In use, the superconductive coil 3 is operated, causing heat to be generated. The heat is transferred by thermal conduction from around the entire circumference of the coil via the highly thermally conductive means 25 to the interior of the cryogen chamber 17 by means of the portion of the thermally conducting means 25 which extends circumferentially around the entire outer circumference of the support and coil, and plugs 27 which penetrate the chamber at circumferentially spaced points. Heat delivered to one part of the cryogen chamber may be distributed to other parts of the chamber by the contact plate 29 soldered to the interior of the cover plate defining the outer wall of the cryogen chamber 17. In this way, even heat generated in upper regions of the coil, which are not radially adjacent to a part of the cryogen chamber 17 containing liquid cryogen, may be distributed to other parts of the cryogen chamber which do contain liquid cryogen by a thermally conductive means in the regions both externally and internally to the cryogen chamber. As a result of the highly thermally conductive means 25, heat may still be transmitted to cryogen in a cryogen chamber despite the presence of the substantial low thermal conductive structural support 12 which is interposed between the coil and the cryogen chamber. '

It will be appreciated that the liquid cryogen may be maintained at any desired level, and, the chamber may, for example be completely filled. However, it has been found that if the level is maintained at less then around 50% of the height of the apparatus, the coil may be rotated up to 90° in either direction about its axis without interfering with operation of the cooling apparatus, as liquid cryogen will simply move within the cryogen chamber to find the same level, leaving a portion of the cryogen chamber free from liquid helium in the upper regions thereof through which vaporized helium may be transmitted to the base of the pipe 31.

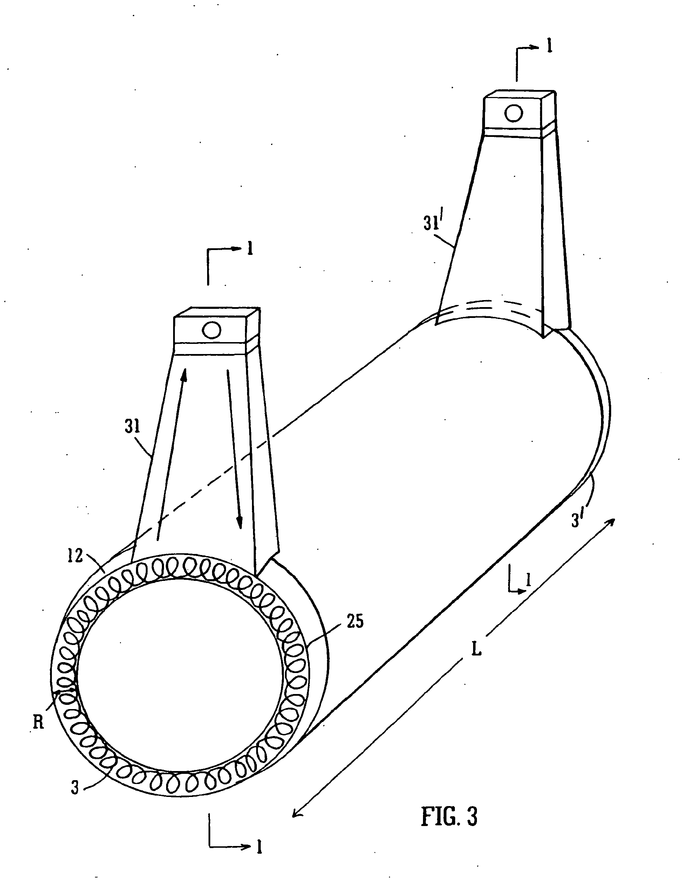

Heat reaching liquid cryogen in the chamber causes the cryogen to be vaporized. The vaporized cryogen moves upwardly in the direction of the arrows in Figures 2 and 3 by diffusion towards the base of the outlet of the pipe 31 leading to the recondensing unit 33. The cryogen flows into contact with the recondensing finger 35 and is cooled, thereby recondensing. The recondensed cryogen drops down onto the outer surface of the support at the base of the pipe and moves under the influence of gravity back into the cryogen chamber.

In this manner, heat is removed from the superconducting coil by the vaporization and recondensation of the cryogen. It will be appreciated that heat is transferred away from the coil by two mechanisms. The heat travels from the coil to the cryogen in the cryogen chamber over the relatively short distance therebetween by a process of conduction via the thermally conductive means. The mechanism used to transfer heat from the cryogen chamber to the recondensing unit is one of diffusion with the cryogen itself acting as the thermal transfer medium. The recondensing unit may be located at any desired distance from the coil by using appropriate pipework. In this manner, the recondensing unit may be located such that it is out of the region which may be subject to interference due to any magnetic field produced by the superconducting coil in use. The use of the cryogen as a heat transfer medium to transfer heat from the cryogen chamber to the recondensing unit over this relatively longer part of the heat transport path between the coil and recondensing unit may avoid the problem of significant temperature gradients arising, as may be experienced if solid conductors are used. Furthermore, the use of vaporised helium as the heat transfer medium may result in a significantly less bulky system, and make transport of heat over greater distances than would be realistic in practice using a thermal conductor possible. By way of example, to conduct 2W of heat over a distance of 1 m, where there is a temperature difference of 0.5K over the path length would by a rough illustrative calculation, require a solid copper thermal link with a conductivity of 600W/m/K, having a diameter of around 100mm and a mass in the order of 60Kg. The mass of the conductor required is proportional to the square of the distance involved. It will be appreciated that the cryogen chamber is local to the superconducting coil in embodiments of the invention, and the thermal conduction is only required to take place over the short range. It has been found that the use of liquid cryogen as a heat transfer medium may also provide better vibration isolation between the recondensing unit and the superconducting coil.

As the superconducting coil does not need to be immersed in a bath or cryogen as in conventional arrangements, the support may be located to the exterior of the coil as shown in the illustrated embodiment. For example, the coil may be reinforced with a stiff collar on its outer surface if desired. This may allow the coil to operate in more extreme conditions than a coil wound conventionally on a mandrel or other internal support, and cooled by a helium bath located around its exterior surface.

As the coils are not supported by an internal former or surrounded by a helium bath, they may be made more compact, increasing their efficiency, and reducing the amount of superconductor required to generate a desired magnetic field.

Furthermore, in contrast to conventional immersion type arrangements, a relatively small quantity of cryogen is required to be located in the cryogen chamber, and the cryogen chamber itself may be reduced in size to provide a more space efficient arrangement. This is because heat may be transported from all regions of the coil using thermally conductive elements to the cryogen chamber rapidly, and without significant losses, and heat may be distributed within the cryogen chamber to ensure that the amount delivered to that cryogen which is provided is maximized.

The cryogen circuit i.e. the cryogen chamber, pipe and recondensing unit, may be sealed, so that throughout the operating cycle, including cooldown, warmup and any quench which may occur, the circuit contains a fixed quantity of cryogenic substance. The sealed circuit may incorporate an expansion vessel to accommodate an increased volume of cryogen at room temperature. In other embodiments, the sealed circuit may be of constant volume, and may be designed to withstand the additional pressure of cryogen when warmed to room temperature.

As the amount of cryogen located in the system is relatively small, in the event that any quench does occur i.e. that the coil changes from a superconductive to a resistive state, converting its magnetic energy to heat, and causing vaporization to most or all of the cryogen, the amount of vapour released may be reduced, to the extent that it may be safely released to the environment, or collected for reuse. As cryogens, such as liquid helium, are likely to become relatively scarce resources, the ability to operate a system using a smaller quantity of helium and which allows the helium to be recycled, is advantageous.

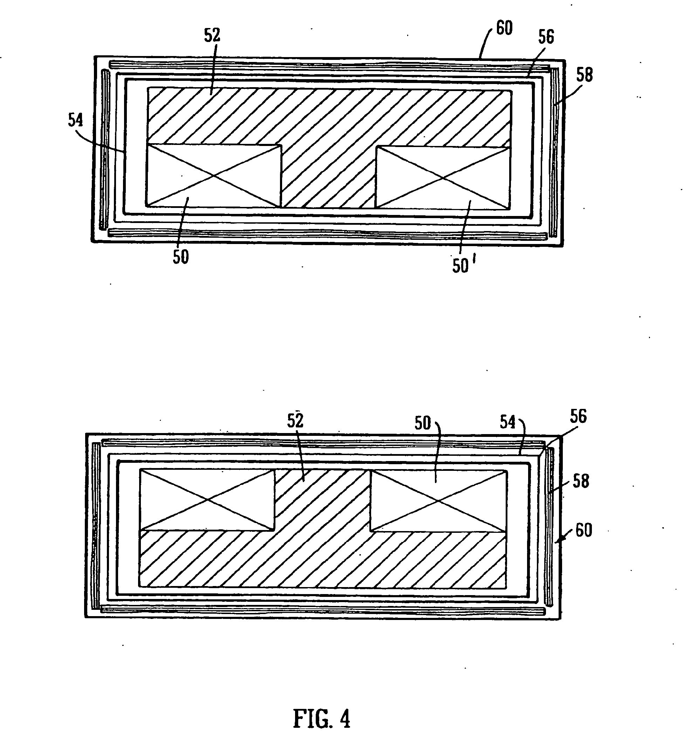

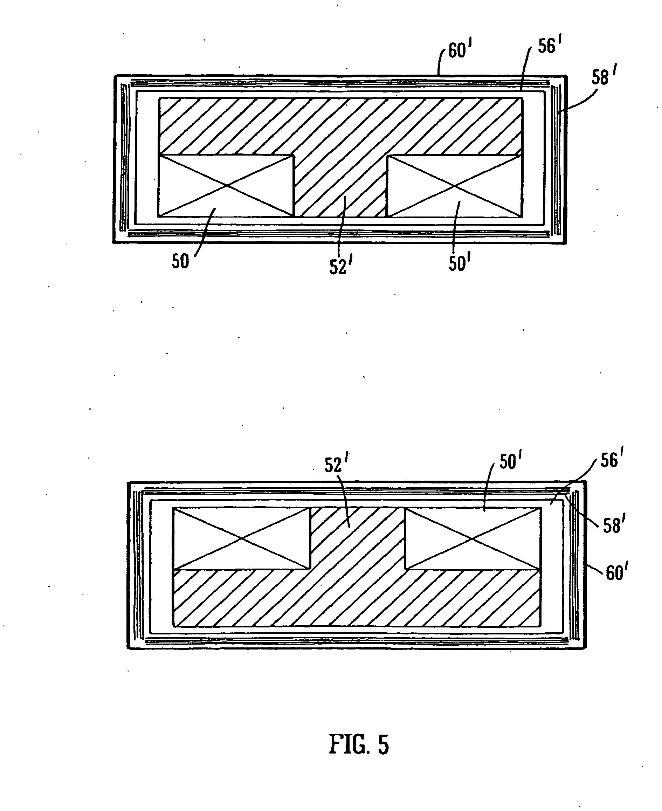

Figures 4 and 5 illustrate the advantages which the present invention may provide by allowing the presence of a helium bath to be eliminated. Figure 4 illustrates the layers which would be involved if the magnet were to be surrounded by a conventional helium bath. The magnetic coil 50 disposed in support 52 is surrounded by a helium vessel which traps a layer of helium 54 between the outer surface of the coil and support and the inner surface of the vessel. In this arrangement, one or more radiation shields 56 are disposed outwardly of the helium vessel. A layer of insulation, such as multilayer insulation 58 is disposed between the radiation shield or shields 56 and the outermost component, which is a vacuum vessel 60.

Figure 5 illustrates how, in accordance with the invention, the helium layer 54 may be eliminated, providing a more compact apparatus, in which the coil may be disposed in its forming element and mounted in a room temperature vacuum vessel separated by one or two thin radiation shields and some multilayer insulation. The radiation shields are arranged to intercept any radiated heat from the environment surrounding the apparatus, which may be for example at room temperature, reducing the heat load on the magnet. The corresponding parts of the system are annotated with a prime sign (" ").

## Claims

1. A superconducting system comprising:
at least one annular superconducting coil (3), and
a cryogen chamber (17) which is situated local to the superconducting coil for containing cryogen in use;
wherein the system further comprises a thermally conductive means (25) arranged to facilitate heat transfer from the at least one superconducting coil (3) to the cryogen chamber (17) to vaporize cryogen contained therein in use and thereby remove heat from the at least one coil, the thermally conductive means (25) being highly thermally conductive at cryogenic temperatures;
wherein the highly thermally conductive means is arranged to provide a direct thermal conduction path between a surface of the superconducting coil and the interior of the cryogen chamber;
wherein the system further comprises a cryogen recondensing unit (33), the cryogen chamber (17) being in fluid communication with the cryogen recondensing unit (33), whereby vaporized cryogen may flow from the cryogen chamber (17) to the cryogen recondensing unit to be recondensed in use before returning to the cryogen chamber, and
**characterised in that** the system is a rotatable system, wherein the coil may be rotated about its axis in use, wherein the cooling of the coit may still occur even when the coil is rotated about its axis in use; and
wherein the system further comprises a support means (12) for supporting the coil, wherein the support means (12) is located between the superconducting coil (3) and the cryogen chamber, wherein the support means (12) at least partially surrounds the coil.

2. The superconducting system according to claim 1, wherein the highly thermally conductive means (25) has a thermal conductivity of at least 200 W/m/K at cryogenic temperatures.

3. The superconducting system in accordance with any one of the preceding claims, wherein the highly thermally conductive means (25) is copper.

4. The superconducting system in accordance with any one of the preceding claims, wherein the highly thermally conductive means (25) is arranged such that it may conduct heat from a part of the cryogen chamber (17) which does not contain cyogen in use to a part of the cryogen chamber which does contain cryogen In use.

5. The superconducting system in accordance with any one of the preceding claims, wherein the cryogen chamber (17) at least partially circumferentially surrounds the coil, preferably wherein the highly thermally conductive means (25) is arranged to conduct heat from a part of the coil which is not surrounded by the cryogen chamber to the cryogen chamber in use.

6. The system of any preceding claim, wherein the system is arranged such that recondensed cryogen may return to the cryogen chamber (17) under the influence of gravity.

7. The superconducting system according to any preceding claim, wherein the superconducting system is a superconducting magnet system, the superconducting coil being arranged to generate a magnetic field when an electric current is passed therethrough.

8. The superconducting system according to any preceding claim, wherein the support means (12) has a thermal conductivity at cryogenic temperatures of less than 10W/m/K.

9. The superconducting system according to any preceding claim, wherein the hghly thermally conductive means (25) has a higher thermal conductivity than the support means (12).

10. The system in accordance with any one of the preceding claim, further comprising cryogen in the cryogen chamber (17), preferably wherein the chamber contains liquid cryogen which fills the cryogen chamber to a level of less than 50% of the height of the chamber.

11. The system of any preceding claim, wherein the system is arranged such that the support means, the cryogen chamber, the thermally conductive means, and the cryogen yogen recondensing unit rotate with the coil as the coil rotates about its axis.

12. The system of any preceding claim, wherein the coil may rotated up to 90° In either direction about its axis without interfering with cooling of rotated up to 90° In either direction about its axis without Interfering with cooling the coil.

13. A method of cooling a superconducting coil using a system in accordance with any one of the claims 1 to 12, the method comprising providing a cryogen in the cryogen chamber (17), and operating the superconducting coil (3), whereby heat from the superconducting coil is conducted by the highly thermally conductive means (25) to the cryogen chamber to vaporize the cryogen therein and thereby remove heat from the coil, the vaporized cryogen flowing to the recondensing unit to be recondensed before returning to the cryogen chamber.

14. The method of claim 13, further comprising providing the cryogen in the cryogen chamber such that the cryogen fills the cryogen chamber to a level of less than 50% of the height of the chamber and rotating the coil about its axis, wherein cooling of the coil still occurs even when the coil is rotated about its axis.

## Patentansprüche

1. Supraleitendes System, umfassend:
zumindest eine ringförmige supraleitende Spule (3), und
eine Kältemittelkammer (17), die sich lokal an der supraleitenden Spule befindet, um in Verwendung ein Kältemittel zu enthalten;
wobei das System ferner ein wärmeleitendes Mittel (25) umfasst, das dazu eingerichtet ist, die Wärmeübertragung von der zumindest einen supraleitenden Spule (3) zu der Kältemittelkammer (17) zu erleichtern, um ein Kältemittel, das darin in Verwendung enthalten ist, zu verdampfen und dadurch Wärme von der zumindest einen Spule zu beseitigen, wobei das wärmeleitende Mittel (25) bei kryogenen Temperaturen stark wärmeleitend ist;
wobei das stark wärmeleitende Mittel dazu eingerichtet ist, einen direkten Wärmeleitweg zwischen einer Oberfläche der supraleitenden Spule und dem Inneren der Kältemittelkammer bereitzustellen;
wobei das System ferner eine Kältemittel-Rekondensationseinheit (33) umfasst, wobei die Kältemittelkammer (17) in einer Fluidverbindung mit der Kältemittel-Rekondensationseinheit (33) steht, wodurch in Verwendung verdampftes Kältemittel von der Kältemittelkammer (17) zu der Kältemittel-Rekondensationseinheit fließen kann, um rekondensiert zu werden, bevor es zu der Kältemittelkammer zurückkehrt, und
**dadurch gekennzeichnet, dass** das System ein drehbares System ist, wobei die Spule in Verwendung um ihre Achse gedreht werden kann, wobei die Kühlung der Spule nach wie vor stattfinden kann, auch wenn die Spule in Verwendung um ihre Achse gedreht ist; und
wobei das System ferner ein Halterungsmittel (12) umfasst, um die Spule zu halten, wobei sich das Halterungsmittel (12) zwischen der supraleitenden Spule (3) und der Kältemittelkammer befindet, wobei das Halterungsmittel (12) die Spule zumindest teilweise umgibt.

2. Supraleitendes System nach Anspruch 1, wobei das stark wärmeleitende Mittel (25) bei kryogenen Temperaturen eine Wärmeleitfähigkeit von zumindest 200 W/m/K aufweist.

3. Supraleitendes System nach einem der vorhergehenden Ansprüche, wobei das stark wärmeleitende Mittel (25) Kupfer ist.

4. Supraleitendes System nach einem der vorhergehenden Ansprüche, wobei das stark wärmeleitende Mittel (25) so angeordnet ist, dass es Wärme von einem Teil der Kältemittelkammer (17), der in Verwendung kein Kältemittel enthält, zu einem Teil der Kältemittelkammer, der in Verwendung ein Kältemittel enthält, leiten kann.

5. Supraleitendes System nach einem der vorhergehenden Ansprüche, wobei die Kältemittelkammer (17) die Spule zumindest teilweise umfänglich umgibt, wobei das stark wärmeleitende Mittel (25) vorzugsweise dazu eingerichtet ist, in Verwendung Wärme von einem Teil der Spule, der nicht von der Kältemittelkammer umgeben ist, zu der Kältemittelkammer zu leiten.

6. System nach einem vorhergehenden Anspruch, wobei das System so eingerichtet ist, dass das rekondensierte Kältemittel unter Schwerkrafteinfluss zu der Kältemittelkammer (17) zurückkehren kann.

7. Supraleitendes System nach einem vorhergehenden Anspruch, wobei das supraleitende System ein supraleitendes Magnetsystem ist, wobei die supraleitende Spule dazu eingerichtet ist, ein Magnetfeld zu erzeugen, wenn ein elektrischer Strom hindurchgeführt wird.

8. Supraleitendes System nach einem vorhergehenden Anspruch, wobei das Halterungsmittel (12) eine Wärmeleitfähigkeit bei kryogenen Temperaturen von weniger als 10 W/m/K aufweist.

9. Supraleitendes System nach einem vorhergehenden Anspruch, wobei das stark wärmeleitende Mittel (25) eine höhere Wärmeleitfähigkeit als das Halterungsmittel (12) aufweist.

10. System nach einem der vorhergehenden Ansprüche, ferner umfassend ein Kältemittel in der Kältemittelkammer (17), wobei die Kammer vorzugsweise ein flüssiges Kältemittel enthält, das die Kältemittelkammer bis zu einem Pegel von weniger als 50 % der Höhe der Kammer füllt.

11. System nach einem vorhergehenden Anspruch, wobei das System so eingerichtet ist, dass sich das Halterungsmittel, die Kältemittelkammer, das wärmeleitende Mittel und die Kältemittel-Rekondensationseinheit mit der Spule drehen, wenn sich die Spule um ihre Achse dreht.

12. System nach einem vorhergehenden Anspruch, wobei die Spule in beide Richtungen um bis zu 90° um ihre Achse gedreht werden kann, ohne die Kühlung der Spule zu beeinträchtigen.

13. Verfahren zum Kühlen einer supraleitenden Spule unter Verwendung eines Systems nach einem der Ansprüche 1 bis 12, wobei das Verfahren Bereitstellen eines Kältemittels in der Kältemittelkammer (17) und Betreiben der supraleitenden Spule (3) umfasst, wodurch Wärme von der supraleitenden Spule durch das stark wärmeleitende Mittel (25) zu der Kältemittelkammer geleitet wird, um das Kältemittel darin zu verdampfen und dadurch Wärme von der Spule zu beseitigen, wobei das verdampfte Kältemittel zu der Rekondensationseinheit fließt, um rekondensiert zu werden, bevor es zu der Kältemittelkammer zurückkehrt.

14. Verfahren nach Anspruch 13, ferner umfassend ein derartiges Bereitstellen des Kältemittels in der Kältemittelkammer, dass das Kältemittel die Kältemittelkammer bis zu einem Pegel von weniger als 50 % der Höhe der Kammer füllt, und ein Drehen der Spule um ihre Achse, wobei das Kühlen der Spule nach wie vor stattfindet, auch wenn die Spule um ihre Achse gedreht ist.

## Revendications

1. Système supraconducteur comprenant :
au moins une bobine supraconductrice annulaire (3) et
une chambre (17) à cryogène située à proximité de la bobine supraconductrice et qui en utilisation contient un cryogène,
le système comprenant de plus des moyens (25) thermiquement conducteurs agencés pour permettre le transfert de chaleur depuis la ou les bobines supraconductrices (3) vers la chambre (17) à cryogène pour vaporiser le cryogène qui y est contenu en utilisation et pour évacuer de cette façon la chaleur de la ou des bobines, les moyens (25) thermiquement conducteurs étant des moyens à haute conduction thermique aux températures cryogéniques,
les moyens à haute conduction thermique étant agencés pour permettre un parcours direct de conduction thermique entre une surface de la bobine supraconductrice et l'intérieur de la chambre cryogène,
le système comprenant de plus une unité (33) de recondensation de cryogène, la chambre (17) à cryogène étant en communication d'écoulement avec l'unité (33) de recondensation de cryogène, le cryogène vaporisé pouvant s'écouler de la chambre (17) à cryogène vers l'unité de recondensation de cryogène afin d'être en utilisation recondensé avant de retourner vers la chambre à cryogène,
**caractérisé en ce que**
le système est un système rotatif, la bobine pouvant en utilisation tourner autour de son axe, le refroidissement de la bobine pouvant encore se produire lorsque en utilisation la bobine tourne autour de son axe et
**en ce que** le système comprend de plus des moyens (12) de support qui supportent la bobine, les moyens (12) de support étant situés entre la bobine supraconductrice (3) et la chambre à cryogène, les moyens (12) de support entourant au moins partiellement la bobine.

2. Système supraconducteur selon la revendication 1, dans lequel les moyens (25) à haute conduction thermique présentent une conductivité thermique d'au moins 200 W/m.K aux températures cryogéniques.

3. Système supraconducteur selon l'une quelconque des revendications précédentes, dans lequel les moyens (25) à haute conduction thermique sont en cuivre.

4. Système supraconducteur selon l'une quelconque des revendications précédentes, dans lequel les moyens (25) à haute conduction thermique sont agencés de manière à pouvoir conduire de la chaleur entre une partie de la chambre (17) à cryogène qui en utilisation ne contient pas de cryogène et une partie de la chambre à cryogène qui en utilisation contient du cryogène.

5. Système supraconducteur selon l'une quelconque des revendications précédentes, dans lequel la chambre (17) à cryogène entoure au moins une partie de la circonférence de la bobine, les moyens (25) à haute conduction thermique étant de préférence agencés pour en utilisation conduire la chaleur entre une partie de la bobine qui n'est pas entourée par la chambre à cryogène et la chambre à cryogène.

6. Système selon l'une quelconque des revendications précédentes, dans lequel le système est agencé de manière à ce que le cryogène recondensé puisse retourner vers la chambre (17) à cryogène sous l'action de la gravité.

7. Système supraconducteur selon l'une quelconque des revendications précédentes, dans lequel le système supraconducteur est un système d'aimant supraconducteur, la bobine supraconductrice étant agencée pour créer un champ magnétique lorsqu'un courant électrique la traverse.

8. Système supraconducteur selon l'une quelconque des revendications précédentes, dans lequel les moyens (12) de support présentent aux températures cryogéniques une conductivité thermique de moins de 10 W/m.K.

9. Système supraconducteur selon l'une quelconque des revendications précédentes, dans lequel les moyens (25) à haute conduction thermique présentent une conductivité thermique supérieure à celle des moyens (12) de support.

10. Système selon l'une quelconque des revendications précédentes, comprenant de plus un cryogène dans la chambre (17) à cryogène, la chambre contenant de préférence un cryogène liquide qui remplit la chambre cryogène à un niveau inférieur à 50 % de la hauteur de la chambre.

11. Système selon l'une quelconque des revendications précédentes, dans lequel le système est agencé de manière à ce que les moyens de support, la chambre à cryogène, les moyens thermiquement conducteurs et l'unité de recondensation du cryogène tournent avec la bobine lorsque la bobine tourne autour de son axe.

12. Système selon l'une quelconque des revendications précédentes, dans lequel la bobine peut tourner jusqu'à 90° autour de son axe dans chaque sens sans interférer avec le refroidissement de la bobine.

13. Procédé de refroidissement d'une bobine supraconductrice utilisant un système selon l'une quelconque des revendications 1 à 12, le procédé comprenant l'étape qui consiste à prévoir un cryogène dans la chambre (17) à cryogène et à faire fonctionner la bobine supraconductrice (3), la chaleur provenant de la bobine supraconductrice étant conduite par les moyens (25) à haute conduction thermique vers la chambre cryogène afin de vaporiser le cryogène qui y est contenu et d'évacuer de cette façon la chaleur de la bobine, le cryogène vaporisé s'écoulant vers l'unité de recondensation afin d'y être recondensé avant de retourner vers la chambre cryogène.

14. Procédé selon la revendication 13, comprenant de plus l'étape qui consiste à fournir le cryogène dans la chambre à cryogène de manière à ce que le cryogène remplisse la chambre à cryogène à un niveau inférieur à 50 % de la hauteur de la chambre et à faire tourner la bobine autour de son axe, le refroidissement de la bobine ayant lieu même lorsque la bobine tourne autour de son axe.
